Europäisches Patentamt

European Patent Office

Office européen des brevets

(11) Veröffentlichungsnummer: **0 330 983**

**A2**

## EUROPÄISCHE PATENTANMELDUNG

(21) Anmeldenummer: 89103057.9

(22) Anmeldetag: 22.02.89

(51) Int. Cl.⁴: **H03C 3/22 , H03B 5/18 , H03C 3/09**

(30) Priorität: 01.03.88 DE 3806462
12.08.88 DE 3827429

(43) Veröffentlichungstag der Anmeldung:
06.09.89 Patentblatt 89/36

(84) Benannte Vertragsstaaten:
AT CH DE ES FR GB LI SE

(71) Anmelder: **Licentia Patent-Verwaltungs-GmbH**
**Theodor-Stern-Kai 1**
**D-6000 Frankfurt/Main 70(DE)**

(72) Erfinder: **Kubetzko, Dietrich, Dipl.-Ing.**

**D-7915 Elchingen 3(DE)**

(74) Vertreter: **Schulze, Harald Rudolf, Dipl.-Ing. et al**
**Licentia Patent-Verwaltungs-GmbH**
**Theodor-Stern-Kai 1**
**D-6000 Frankfurt/Main 70(DE)**

(54) **Spannungsgesteuerter Oszillator mit Leitungsresonator.**

(57) Bei einem als Frequenz- und/oder Phasenmodulator wirkenden spannungsgesteuerten Oszillator mit Leitungsresonator und variierbaren Beschaltungskapazitäten wird der Modulationszweig der Beschaltungskapazitäten zwischen den Resonatorenden an den Leitungsresonator angekoppelt, wobei die Lage des Ankoppelpunktes so gewählt ist, daß der Frequenzhub der Modulation über einen größeren Trägerfrequenzbereich im wesentlichem konstant ist.

FIG. 3

## Spannungsgesteuerter Oszillator mit Leitungsresonator

Die Erfindung betrifft einen spannungsgesteuerten Oszillator, auch "Voltage-Controlled-Oscillator" oder kurz "VCO" genannt, gemäß dem Oberbegriff des Patentanspruchs 1. Ein socher Oszillator ist beispielsweise in dem Lehrbuch von V. Manassewitsch: "Frequency Synthesizers-Theory and Design" (John Wiley & Sons, New York, 1976), S. 384-389 beschrieben.

Oszillatoren dieser Art werden beispielsweise als Frequenz-und/oder Phasenmodulatoren eingesetzt. Über eine Phasenregelschleife in Frequenz und/oder Phasenlage geregelt, eignen sie sich besonders für den Einsatz als direkt modulierbare Synthesizer insbesondere für den Frequenzbereich von ca. 200 MHz bis ca. 2 GHz. Solche Synthesizer werden beispielsweise in Funksprechgeräten eingesetzt.

Herzstück des bekannten VCO's ist ein schwingfähiges passives Netzwerk, daß aus einem Leitungsresonator und aus variierbaren Beschaltungskapazitäten besteht. Üblicherweise wird als Leitungsresonator eine Koaxialleitung eingesetzt. Die Beschaltungskapazitäten bestehen in der Regel aus Kombinationen von Kondensatoren und Kapazitätsvariationsdioden.

In dem passiven Netzwerk, das an eine Gleichspannungsversorgung angeschlossen ist, wird eine durch ihre Amplitude, Frequenz und Phasenlage definierte elektromagnetische Schwingung, im folgenden kurz "Trägerschwingung" oder "Schwingung" genannt, erzeugt und über einen Ausgangszweig ausgekoppelt. Zur Aufrechterhaltung der Schwingung bzw. zum Ausgleich der Dämpfungsverluste ist ein aktiver Vierpol (meist in Form eines beschalteten Transistors) an das passive Netzwerk angeschlossen.

Durch Variation der Kapaziät der Kapazitätsdioden wird die Frequenz und/oder Phasenlage der Trägerschwingung in den passiven Netzwerk variiert. Hierzu werden den Kapazitätsdioden über Filter (beispielsweise LC-Filter), die der hochfrequenten Entkopplung dienen, entsprechende Steuerspannungen zugeführt.

Im allgemeinen bestehen die Beschaltungskapazitäten aus mehreren Zweigen, die an den beiden Enden des Leitungsresonators angeschlossen sind. Einer dieser Zweige weist in der Regel eine feste Kapazität auf und besteht beispielsweise aus einer Reihenschaltung zweier Kondensatoren. Die weiteren Zweige sind in ihrer Kapazität variierbar und bestehen im allgemeinen aus einer Reihenschaltung eines Kondensators mit einer Kapazitäszvariationsdiode. Üblicherweise ist einer der variierbaren Zweige zur Einstellung bzw. Abstimmung der Frequenz der Trägerschwingung vorgesehen ("Abstimmzweig") und ein anderer Zweig für die Modulation der Frequenz und/oder Phasenlage der abgestimmten Trägerschwingungen ("Modulationszweig"). Entsprechend wird der einen Kapazitätsvariationsdiode eine Trägerabstimm-Steuerspannung oder kurz Abstimmspannung $U_T$ und der anderen Kapazitätsvariationsdiode eine Modulations-Steuerspannung oder kurz Modulationsspannung $U_M$ zugeführt.

Die Gleichspannungsversorgung wird üblicherweise nicht direkt, sondern über ein Filter (beispielsweise ein LC-Filter) dem passiven Netzwerk zugeführt. Das Filter dient dabei der hochfrequenten Entkopplung der Gleichspannungsversorgung vom passiven Netzteil.

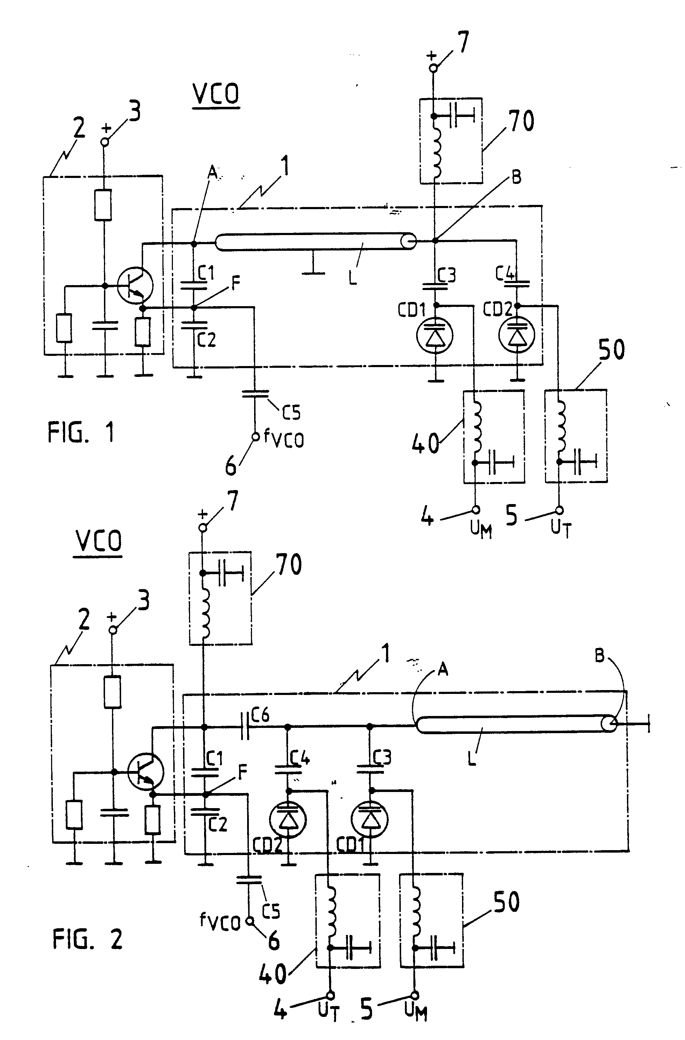

Dieses an sich bekannte Grundkonzept eines VCO's mit Leitungsresonator ist auf vielerlei Art und Weise variiert worden, wie die bekannten Ausführungsbeispiele in den Figuren 1 und 2 zeigen.

In den Figuren ist mit 1 das passive Netzwerk, mit 2 der aktive Vierpol (in Form eines beschalteten npn-Bipolar-transistors), mit 3 die Anschlußklemme für die Gleichspannungsversorgung des aktiven Vierpols 2, mit 4 bzw. 5 die Anschlußklemmen der Modulationsspannung $U_M$ bzw. der Abstimm spannung $U_T$, mit 6 der Ausgang des VCO's, mit 7 die Anschlußklemme für die Gleichspannungsversorgung des passiven Netzwerks 1 und mit 40, 50 und 70 die Filter (in Form von LC-Filtern) zur hochfrequenten Entkopplung der Versorgungsbzw. Steuerteils des VCO's bezeichnet. Die Kondensatoren C5 und C6 (letzterer nur in FIG. 2) dienen der Gleichspannungsentkopplung.

Das passive Netzwerk 1 besteht aus dem Leitungsresonator L in Form einer Koaxialleitung. Die Beschaltungskapazitäten bestehen aus drei Zweigen, die an den Enden A und/oder B des Leitungsresonators L angekoppelt sind. Der eine Zweig besteht aus zwei in Reihe geschalteten Kondensatoren C1 und C2 und hat somit eine feste Kapazität. Die anderen beiden Zweige bestehen jeweils aus einer Reihenschaltung eines Kondensators C3 bzw. mit einer Kapazitätsvariationsdiode CD1 bzw. CD2 und stellen den Modulationszweig bzw. den Abstimmzweig des passiven Netzwerks 1 dar. Alle drei Zweige sind jeweils mit einem ihrer beiden Enden an den Innenleiter der Koaxialleitung L angekoppelt und mit ihrem anderen Ende an Masse angeschlossen. Die Steuerspannungen $U_M$ und $U_T$ werden jeweils einem Punkt zwischen Kapazitätzvariationsdiode CD1 bzw. CD2 und Kondensator C3 bzw. C4 zugeführt.

Die Trägerfrequenz wird in beiden Ausführungsbeispielen mittels der Kapazitätsdiode CD2 variiert. Die Frequenz- bzw. die Phasenmodulation des Trägers wird mit Hilfe der Kapazitätsdiode CD1 realisiert. Diese Schaltungen zeigen nur über einen sehr begrenzten Variationsbereich der Trägerfrequenz (ca. 1 %) ein ausreichend konstantes Modulationsverhalten.

Denn mit steigender Trägerfrequenz steigt der Frequenzhub der Modulation überproportional an, da durch die dazu erforderliche Verringerung der Kapazität der Diode CD2 im Abstimmzweig oder kurz der "Abstimmdiode" CD2 der Einfluß der Diode im Modulationszweig oder kurz der "Modulationsdiode" CD1 zunimmt. Auch wenn mann, wie in FIG. 2 gezeigt, die beiden Dioden CD1 und CD2 an das andere Resonatorende A verlagert, ändert sich an diesem Verhalten kaum etwas, es ergibt sich nur eine geringfügige Verbesserung.

Aus der DE-OS 27 06 662 ist bekannt, den Frequenzhub der Modulation durch geeignete Variation der Vorspannung der Modulationsdiode CD1 (Grundkapazität) konstant zu halten. Das funktioniert bei einem VCO mit Leitungsresonator allerdings nur bedingt und macht zusätzlichen Aufwand, da ein weiterer Operationsverstärker mit Beschaltung erforderlich ist.

Die Aufgabe der Erfindung besteht darin, einen VCO der eingangs genannten Art zu schaffen, der als Frequenz- und/oder Phasenmodulator in einem möglichst großen Trägerfrequenzbereich eine von der Trägerfrequenz möglichst wenig beeinflußte Modulationssteilheit aufweist. Darüber hinaus sollte der zu schaffende VCO möglichst wenig aufwendig sein und sich gegebenenfalls auch noch über eine Phasenregelschleife mit einem Split-Loop-Filter regeln lassen.

Die erfindungsgemäße Lösung der Aufgabe ist im Patentanspruch 1 beschrieben. Die Unteransprüche enthalten vorteilhafte Aus- und Weiterbildungen der Erfindung sowie bevorzugte Anwendungen der Erfindung.

Die bekannten VCO's gehen bei der Konzeption des passiven Netzwerks davon aus, daß der Leitungsresonator und die einzelnen Zweige der Beschaltungskapazitäten in sich abgeschlossene Einheiten bilden, die auch nur als solche miteinander zu einem Netzwerk verbindbar sind. Konsequenterweise werden daher bei den bekannten VCO's trotz vielfältiger Unterschiede im übrigen Aufbau die einzelnen Zweige der Beschaltungskapazitäten grundsätzlich nur an einem oder an beiden Enden des Leitungsresonators angekoppelt. Die internen Eigenschaften des Leitungsresonators werden somit bei diesen bekannten Konzepten nicht genutzt.

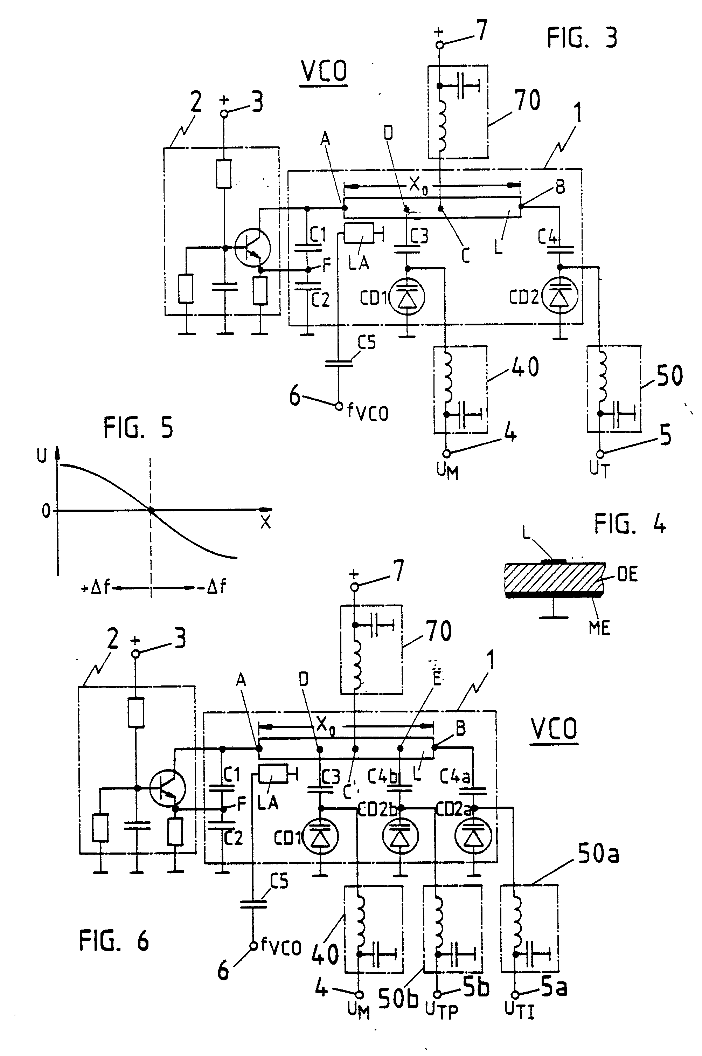

Im Gegensatz hierzu geht die erfindungsgemäße Lösung davon aus, daß sich aber gerade diese internen Eigenschaften des Leitungsresonators vorteilhaft nutzen lassen, um ein optimal gestaltetes passives Netzwerk zu schaffen. Die Erfindung basiert auf der Erkenntnis, daß sich im Leitungsresonator ein Spannungsknoten S zwischen den beiden Resonatorenden ausbildet (vgl. FIG. 5), dessen räumliche Lage im wesentlichen durch das Verhältnis der wirksamen Beschaltungskapazitäten an den beiden Enden des Leitungsresonators bestimmt ist. Wird z.B. die Kapazität der Kapazitätsvariationsdiode CD2 in FIG. 1 verringert, so erhöht sich die Resonanzfrequenz der Leitungsresonators L, welche der Oszillatorfrequenz $f_{VCO}$ entspricht. Der Spannungsknoten S entfernt sich dabei zunehmend von dem Leitungsende B, an welchem die Abstimmdiode CD2 angekoppelt ist, in Richtung des anderen Leitungsendes A.

Wird nun der Modulationszweig C3, CD1 nicht, wie in FIG. 1 oder 2 gezeigt, an einem der beiden Enden A oder B des Leitungsresonators L angekoppelt, sondern erfindungsgemäß an einem ersten Punkt zwischen der beiden Resonatorenden, läßt sich bei geschickter Wahl des Ankoppelpunktes erreichen, daß der Frequenzhub der Modulation über einen größeren, durch eine erste untere und eine erste obere Grenzfrequenz definierten Trägerfrequenzbereich im wesentlichen konstant ist.

Wird die Lage des ersten Ankoppelpunktes beispielsweise so gewählt, daß der Spannungsknoten S mit steigender Trägerfrequenz $f_{VCO}$, d.h. bei Verringerung der Kapazität/der Kapazitätsvariationsdiode im Abstimmzweig, auf den ersten Ankoppelpunkt zuwandert, dann wird der Einfluß des Modulationszweiges auf die Trägerfrequenz $f_{VCO}$ Oszillators immer geringer, je näher sich Spannungsknoten S und erster Ankoppelpunkt kommen.

Im Grenzfall, daß Spannungsknoten und erster Ankoppelpunkt räumlich zusammenfallen, ist der Modulationszweig unwirksam. Aufgrund der vorangegangenen Überlegungen läßt sich daher im Experiment jener erster Ankoppelpunkt der Modulationszweiges im Leitungsresonator finden, für welchen über einen größeren Bereich der Trägerfrequenz, als Folge der Variation der Kapazitätsvariationsdiode im Abstimmzweig der Frequenzhub der Modulation im wesentlichen konstant bleibt.

In vorteilhaften Ausführungsformen der Erfindung wird die Lage des ersten Ankoppelpunktes dabei so gewählt, daß dieser immer außerhalb des Resonatorstückes liegt, das durch die räumliche Lage des Spannungsknotens bei den beiden oben erwähnten ersten Grenzfrequenzen begrenzt ist.

Der zuvor beschriebene Effekt läßt sich auch umkehren, in dem man den Abstimmzweig in einen Grobzweig und einen Feinzweig aufteilt und beide Zweige, bezogen auf die räumliche Lage des Spannungsknotens bei Frequenzen aus einem bestimmten Trägerfrequenzbereich, auf der gleichen Seite des Leitungsresonators ankoppelt, wobei der Grobzweig vorzugsweise an dem entsprechenden Resonatorende und der Feinzweig an einem Punkt zwischen den Spannungsknoten und diesem Resonatorende angekoppelt ist. Jeder der beiden Zweige enthält dabei eine eigene Kapazitätsvariationsdiode, deren Kapazität über eine entsprechende Steuerspannung variiert wird.

Diese Konfiguration ist besonders vorteilhaft einsetzbar in Phasenregelschleifen mit einem Split-Loop-Filter zur Realisierung von konstanten Einschwingzeiten bei großem Variationsbereich (ca. 30 %) der Trägerfrequenz.

Weiterhin ist vorteilhaft, beide Möglichkeiten miteinander zu kombinieren. Mit der Kombination erhält man einen VCO für einen direkt modulierbaren Synthesizer großer Schaltbandbreite (hohe Kanalzahl) und gleichzeitig annähernd konstanter Frequenzwechselzeit (Einschwingzeit) bei ebenfalls annähernd konstantem Modulationsfrequenzhub. Der Trägerfrequenzbereich, der sich mit dem erfindungsgemäßen VCO besonders vorteilhaft realisieren läßt, reicht von ca. 200 MHz bis ca. 2 GHz.

Vorzugsweise wird der Leitungsresonator bei der erfindungsgemäßen Lösung durch eine offene gedruckte Leitung bzw. Streifenleitung realisiert, die auf einem dielektrischem Substrat aufgebracht ist, dessen metallisierte Bodenfläche an Masse angeschlossen ist.

Im folgenden wird die Erfindung anhand der Figur näher erläutert. Es zeigen

FIG. 1 das bereits diskutierte Schaltbild eines bekannten VCO's mit Leitungsresonator;

FIG. 2 das bereits diskutierte Schaltbild eines anderen bekannten VCO's mit Leitungsresonator;

FIG. 3 das Schaltbild einer vorteilhaften Ausführungsform des erfindungsgemäßen VCO's;

FIG. 4 den Leitungsresonator der Ausführungsform des erfindungsgemäßen VCO's gemäß FIG. 3 im Querschnitt;

FIG. 5 den Spannungsverlauf U (x) längs des Leitungsresonators des erfindungsgemäßen VCO's;

FIG. 6 das Schaltbild einer weiteren vorteilhaften Ausführungsform des erfindungsgemäßen VCO's;

Fl. 7 das Blockschaltbild einer Phasenregelschleife mit dem erfindungsgemäßen VCO gemäß FIG. 3 als Frequenz- und/oder Phasenmodulator;

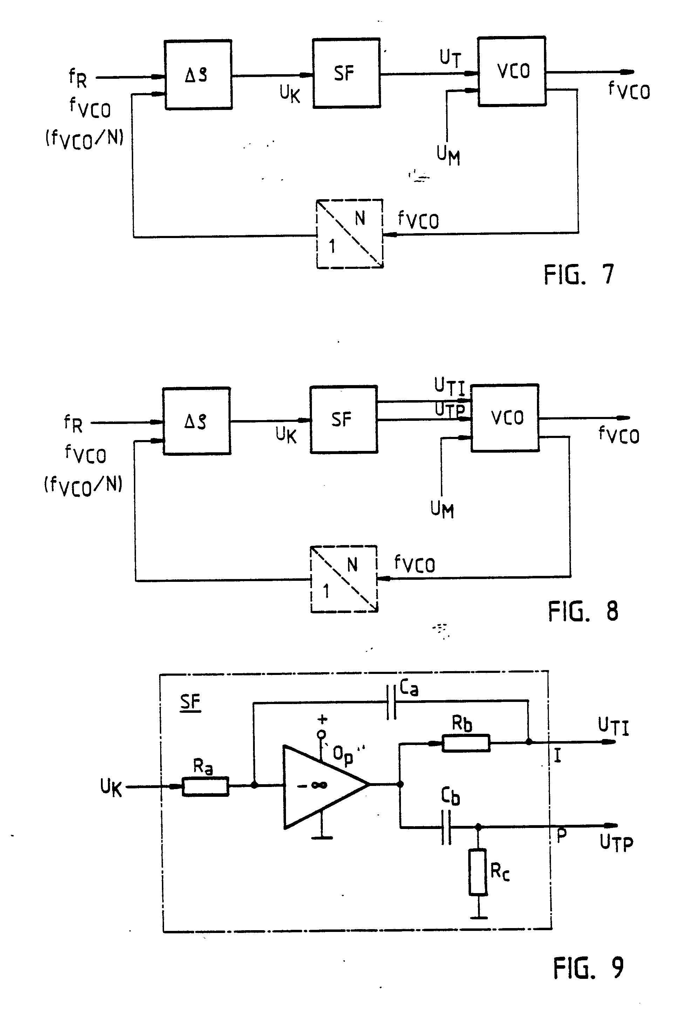

FIG. 8 das Blockschaltbild einer Phasenregelschleife mit einem Split-Loop-Filter und dem erfindungsgemäßen VCO gemäß FIG. 6 als Frequenz- und/oder Phasenmodulator;

FIG. 9 das Schaltbild einer vorteilhaften Ausführungsform eines Split-Loop-Filters gemäß einer anderen, noch nicht veröffentlichten Anmeldung P .. .. ...(UL 87/126) der Anmelderin.

Der erfindungsgemäße VCO in FIG. 3 besteht ebenso wie die bekannten VCO's der Figuren 1 und 2 aus einem schwingfähigen passiven Netzwerk 1, einem aktiven Vierpol 2 in Form eines beschalteten npn-Transistors, Anschlußklemmen 3 bzw. 7 für die Gleichspannungsversorgung des aktiven Vierpols 2 bzw. des passiven Netzwerks 1, Anschlußklemmen 4 bzw. 5 für die Modulationsspannung $U_M$ bzw. die Abstimmspannung $U_T$ sowie einen Ausgang 6 zur Auskopplung der erzeugten Trägerschwingung mit der Frequenz $f_{VCO}$. Zur hochfrequenzmäßigen Entkopplung der Versorgungs- und Steuerteile des VCO's sind Filter 40, 50 und 70 vorgesehen. Der Kondensator C5 dient der Gleichspannungsentkopplung.

Der Deutlichkeit halber wurden bei diesem Ausführungsbeispiel des erfindungsgemäßen VCO's ebenso wie in dem weiteren

Ausführungsbeispiel in FIG. 6 mit Ausnahme der erfindungswesentlichen Merkmale im übrigen der gleiche Aufbau gewählt wie bei dem bekannten VCO in FIG. 1 und zum Teil wie bei dem bekannten VCO in FIG. 2.

So sind beispielsweise die Filter 40, 50 und 70 zur hochfrequenzmäßigen Entkopplung sowie der aktive Vierpol 2 in allen Figuren 1-3 und 6 von Aufbau her gleich. Auch der prinzipielle Aufbau der einzelnen Zweige der Beschaltungskapazitäten ist in allen Figuren 1-3 und 6 gleich.

So besteht der Zweig mit fester Kapazität aus zwei in Reihe geschalteter Kondensatoren C1 und C2 und ist an dem Ende A des Leitungsresonators L angekopplet, an dem auch der aktive Vierpol 2 angekoppelt ist.

Die anderen Zweige mit variierbarer Kapazität bestehen jeweils aus einer Reihenschaltung eines Kondensators C3 bzw. C4 bzw. C4a bzw. C4b mit einer einseitig an Masse angeschlossenen Kapazitätsvariationsdiode CD1 bzw. CD2 bzw. CD2a bzw. CD2b, wobei die entsprechenden Steuerspannungen $U_M$ bzw. $U_T$ bzw. $U_{TI}$ bzw. $U_{TP}$ jeweils an einem Punkt zwischen Kondensator und Kapazitätzvariationsdiode zugeführt werden.

Ein erster erfindungswesentlicher Unterschied des erfindungsgemäßen VCO nach FIG. 3 oder 6 zu den bekannten VCO's nach FIG. 1 oder 2 besteht darin, daß der Modulationszweig C3, CD1 nicht mehr an einem der Resonatorenden A oder B an den Leitungsresonator L angekoppelt ist, sondern er findungsgemäß an einen ersten Punkt D zwischen den beiden Resonatorenden A und B.

Die räumliche Lage dieses Ankoppelpunkts D ist dabei so gewählt, daß der Frequenzhub der Modulation über einen größeren, durch eine erste untere und eine erste obere Grenzfrequenz definierten Trägerfrequenzbereich im wesentlichen konstant ist.

Dabei liegt der Ankoppelpunkt immer außerhalb des Reonatorstückes, das durch die räumliche Lage des Spannungsknotens S (vgl. FIG. 5) bei den beiden oben erwähnten ersten Grenzfrequenzen gegeben ist, die den gewünschten Trägerfrequenzbereich festlegen.

Ein weiterer erfindungswesentlicher Unterschied des erfindungsgemäßen VCO nach FIG. 3 oder 6 zu den bekannten VCO's nach FIG. 1 oder 2 besteht darin, daß auch die Gleichspannungsversorgung 7,70 des passiven Netzwerkes 1 nicht mehr an einem der Resonatorenden A oder B an das passive Netzwerk angekoppelt ist, sondern an einen dritten Punkt C zwischen den Resonatorenden A und B. Die Lage dieses dritten Ankoppelpunktes ist dabei vorteilhafterweise so gewählt, daß er mit der Lage des Spannungsknotens S bei der mittleren Trägerfrequenz übereinstimmt (oder zumindest annähernd übereinstimmt). Mit dieser Maßnahme wird erreicht, daß allein durch die räumliche Lage der Ankopplung der Gleichspannungsversorgung 7 an das passive Netzwerk 1 für einen relativ großen Trägerfrequenzbereich bereits eine gute hochfrequenz mäßige Entkopplung der Gleichspannungsversorgung 7 gegeben ist, die durch das Filter 70 noch weiter verbessert wird.

Ein dritter erfindungswesentlicher Unterschied des erfindungsgemäßen VCO nach FIG. 3 oder 6 zu den bekannten VCO's nach FIG. 1 oder 2 besteht darin, daß der Leitungsresonator nicht aus einer Koaxialleitung besteht, sondern aus einer offenen gedruckten Leitung L der Länge $x_o$, die gemäß FIG. 5 auf einen dielektrischen Substrat DE aufgebracht ist, dessen metallisierte Bodenfläche ME an Masse angeschlossen ist. Diese Leitung wirkt aufgrund ihrer Beschaltung durch die Beschaltungskapazitäten wie ein verkürzter 1/2-Resonator.

Der wesentliche Vorteil dieser Maßnehme besteht darin, daß der Resonator auf der gesamten Länge $x_o$ frei zugänglich ist, so daß die Ankopplung der einzelnen Baugruppen wie z.B. der Modulationszweig C3, CD1 oder die Gleichspannungsversorgung 7, 70 des passiven Netzwerkes 1 auf besonders einfache Weise bewerkstelligt werden kann.

Ein vierter erfindungswesentlicher Unterschied des erfindungsgemäßen VCO nach FIG. 6 zu den bekannten VCO's nach FIG. 1 oder 2 besteht schließlich darin, daß der Abstimmzweig C4, CD2 in einen Grobzweig C4a, CD2a und einen Feinzweig C4b, CD2b aufgeteilt ist. Die beiden Zweige verfügen über separate Zuleitungen 5a, 50a bzw. 5b, 50b für die entsprechenden Steuerspannungen $U_{TI}$ bzw. $U_{TP}$.

Der Grobzweig C4a, CD2a ist dabei an dem Leitungsende B an den Leitungsresonator L angekoppelt, während der Feinzweig C4b, CD2b an einen zweiten Punkt E zwischen den Resonatorenden A und B an dem Leitungsresonator L angekoppelt ist.

Die räumliche Lage dieses zweiten Ankoppelpunktes ist dabei so gewählt, daß die beiden Zweige, bezogen auf die räumliche Lage des Spannungsknoten S bei Frequenzen aus einem größeren Trägerfrequenzbereich, auf der gleichen Seite der Leitungsresonators liegen. Diese Anordnung eignet sich insbesondere für Anwendungen des erfindungsgemäßen VCO als Frequenz-und/oder Phasenmodulator in einer Phasenregelschleife mit einem sogenannten Split-Loop-Filter, das über eine Integral-und einen Proportionalzweig verfügt und dessen Ausgangsspannungen direkt als Steuerspannungen $U_{TI}$ bzw. $U_{TP}$ dem passiven Netzwerk 1 des erfindungsgemäßen VCO nach FIG. 6 zugeführt werden können.

Zur Funktionsweise der beiden Ausführungsformen des erfindungsgemäßen VCO nach FIG. 3 und 6 ist folgendes zu sagen:

Die offene gedruckte Leitung L wirkt aufgrund der Beschaltungskapazitäten C1, C2, C3, CD1, C4, CD2; C4a, CD2a; C4b, CD2b als verkürzter 1/2-Resonator. Der Spannungsverlauf U (x) längs der Resonatorleitung ist in FIG. 5 dargestellt. Er weist einen Spannungsknoten S zwischen den beiden Leitungsenden A und B auf.

Die räumliche Lage des Spannungsknotens S wird von dem Verhältnis der wirksamen Beschaltungskapazitäten an den Leitungsenden A, B bestimmt. Wird die Kapazität der Kapazitätsvariationsdiode CD2 (FIG. 3) im Modulationszweig verringert, so erhöht sich die Resonanzfrequenz des Leitungsresonators, welche der Oszillatorfrequenz $f_{VCO}$ entspricht. Der Spannungsknoten S entfernt sich dabei zunehmend von dem Leitungsende B, an welchem die Diode CD2 angekoppelt ist, in Richtung des anderen Leitungsendes A.

Die Kapazitätsvariationsdiode CD1 im Modulationszweig ist nun so an den Leitungsresonator L angekoppelt, daß der Spannungsknoten S mit steigender Schwingfrequenz $f_{VCO}$, d.h. bei entsprechender Verringerung der Kapazität der Diode CD2, auf den ersten Ankoppelpunkt D zuwandert. Je näher sich der erste Ankoppelpunkt D und der Spannungsknoten S kommen, um so geringer wird der Einfluß des Modulationszweiges C3, CD1 auf die Schwingfrequenz $f_{VCO}$ des Oszillators.

Im Grenzfall, daß Spannungsknoten S und erster Ankoppelpunkt D räumlich zusammenfallen, ist der Modulationszweig unwirksam. Aufgrund der vorangegangenen Überlegungen läßt sich im Experiment jener erste Ankoppelpunkt des Modulationszweiges C3, CD1 auf der Leitung L finden, für welchen über einen größeren Bereich der Trägerfrequenz, als Folge der Variation der Diode CD2, der Frequenzhub der Modulation praktisch konstant bleibt.

Der zuvor beschriebene Effekt läßt sich für Trägerfrequenzen aus einem größeren Frequenzbereich mit der Anordnung nach Fig. 6 auch umkehren, indem beide Zweige auf der gleichen Seite des Leitungsstück bezüglich des Spannungsknotens des gewünschten Trägerfrequenzbereichs angekoppelt werden.

Diese Konfiguration ist besonders vorteilhaft zur Realisierung von konstanten Einschwingzeiten der erfindungsgemäßen VCO in Phasenregelschleifen mit Split-Loop-Filter bei großem Variationsbereich (ca. 30 %) der Trägerfrequenz.

Weiterhin ist es vorteilhaft beide Möglichkeiten zu kombinieren. Damit erhält man einen VCO für einen direkt modulierbaren Synthesizer großer Schaltbandbreite (hohe Kanalzahl), und gleichzeitig konstante Frequenzwechselzeit (Einschwingzeit) bei ebenfalls konstantem Modulationsfrequenzhub.

In den Figuren 7 und 8 sind Blockschaltbilder solcher Phasenregelschleifen für einen direkt modulierbaren Synthesizer gezeigt.

Sie bestehen aus einem VCO als Frequenz und/oder Phasenmodulator, dessen Ausgangssignal der Frequenz $f_{VCO}$ entweder direkt oder gegebenenfalls über einen Frequenzteiler 1/N einem Phasendetektor $\Delta \rho$ zugeführt wird und dort mit der Phasenlage eines Referenzsignals $f_R$ verglichen wird. Entsprechend der Abweichung der Phasenlage des Oszillatorsignals von der Phasenlage des Referenzsignals wird im Phasendetektor $\Delta \rho$ ein Korrektursignal $U_K$ erzeugt, das über ein Schleifenfilter SF als Steuersignal dem VCO zugeführt wird. Je nachdem, ob es sich bei dem Schleifenfilter SF um ein einfaches Filter mit nur einem Ausgang handelt (FIG. 7) oder um ein Split-Loop-Filter mit einem Intergral- und einem Proportionalausgang (FIG. 8), kann vorteilhaft die Ausführungsform des erfindungsgemäßen VCO gemäß FIG. 3 oder die gemäß FIG. 6 eingesetzt werden.

FIG. 9 schließlich zeigt eine vorteilhafte Ausführungsform eines Split-Loop-Filters SF gemäß einem weiteren, noch nicht veröffentlichter Anmeldung P .. .. ... (UL 87/126) der Anmelderin.

Der erfindungsgemäße Split-Loop-Filter 1 in FIG. 9 besteht aus einem Operationsverstärker OP, der mit seinem invertierenden Eingang zum einen . über einen ersten Widerstand Ra an den Ausgang des Phasendetektors $\Delta \rho$ in FIG. 8 angeschlossen ist und zum anderen über einen ersten Kondensator Ca an den ersten Ausgang I des Split-Loop-Filters SF angeschlossen ist, der den Ausgang des Integralzweiges des Filters bildet.

Ausgangsseitig ist der Operationsverstärker OP zum einen über einen zweiten Widerstand Rb ebenfalls an den ersten Ausgang I des Filters angeschlossen und zum anderen über einen zweiten Kondensator Cb an den zweiten Ausgang P des Filters 1, der den Ausgang des Proportionalzweiges des Filters bildet. Die Verbindung des zweiten Kondensators Cb mit dem zweiten Ausgang P des Filters 1 ist dabei über einen dritten Widerstand Rc an Masse angeschlossen. Die beiden Ausgänge P und I des Filters SF sind mit den entsprechenden Steuereingängen 5a und 5b des erfindungsgemäßen VCO gemäß FIG. 6 verbunden.

Es versteht sich, daß die Erfindung mit fachmännischem Wissen aus- und weitergebildet bzw. an die unterschiedlichen Anwendungen angepaßt werden kann, ohne daß dies hier an dieser Stelle näher erläutert werden müßte.

So ist es z.B. möglich, anstelle der offenen druckten Leitung eine herkömmliches Koaxialleitung als Leitungsresonator einzusetzen. In diesem Fall müßte man zweckmäßigerweise etwa in Höhe der vorgesehenen Ankoppelpunkte C, D bzw. E zwischen den beiden Leitungsenden A, B Bohrungen in den Außenleiter anbringen zur Durchführung der Ankoppelleitungen der entsprechenden anzukoppelnden Baugruppen.

Ferner ist es bei der Verwendung einer offenen gedruckten Leitung als Leitungsresonator möglich, alternativ oder in Ergänzungen zur konventionellen Ankopplung des Oszillator-Ausgangs an das passive netzwerk (vgl. FIG. 1 und 2) eine zweite (kürzere) gedruckte Leitung zur Auskopplung der erzeugten Trägerschwingung auf dem dielektrischen Substrat parallel zur Resonatorleitung anzubringen (vgl. Fig. 3 und 6).

Schließlich ist es möglich, andere an sich bekannte Schaltungen für den aktiven Vierpol oder für die Entkopplungsfilter anstelle der beispielhaft in den Figuren 3 und 6 gezeigten bekannten Schaltungen einzusetzen.

## Ansprüche

1. Spannungsgesteuerter Oszillator (VCO), mit einer Gleichspannungsversorgung, mit einem daran angeschlossenen Leitungsresonator und mit einer ersten variierbaren Beschaltungskapazität zur Erzeugung einer durch ihre Amplitude, Frequenz und Phasenlage definierten elektromagnetischen Trägerschwingung, mit einer zweiten variierbaren Beschaltungskapazität zur Modulation dieser Trägerschwingung in Frequenz und/oder Phasenlage, mit einem aktiven Vierpol zur Aufrechterhaltung der Trägerschwingung und mit einem Ausgangszweig zur Auskopplung der Trägerschwingung, welche Trägerschwingung im Leitungsresonator einen Spannungsknoten ausbildet, dessen räumliche Lage im wesentlichen durch das Verhältnis der wirksamen Beschaltungskapazitäten an den beiden Enden des Leitungsresonators bestimmt ist, dadurch gekennzeichnet, daß die zweite Beschaltungskapazität (C3, CD1) an einem ersten Punkt (D) zwischen den beiden Resonatorenden (A, B) an den Leitungsresonator (L) angekoppelt ist und daß die Lage dieses ersten Ankoppelpunktes (D) so gewählt ist, daß der Frequenzhub der Modulation über einen größeren, durch eine erste untere und eine erste obere Grenzfrequenz definierten Trägerfrequenzbereich im wesentlichen konstant ist (FIG. 3. 4).

2. Spannungsgesteuerter Oszillator nach Anspruch 1, dadurch gekennzeichnet, daß der erste Ankoppelpunkt (D) immer außerhalb eines ersten Resonatorstückes liegt, welches durch die räumliche Lage des Spannungsknotens (S in FIG. 5) bei der ersten oben und bei der ersten unteren Grenzfrequenz begrenzt ist.

3. Spannungsgesteuerter Oszillator nach einem der Ansprüche 1 bis 2, dadurch gekennzeichnet, daß die erste Beschaltungskapazität (C1, C2, C4, CD2) in einem ersten Zweig (C1, C2) mit fester Kapazität und in einem zweiten Zweig (C4, CD2) mit variierbarer Kapazität aufgeteilt ist und daß die Zweige (C1, C2; C4, CD2) an unterschiedlichen Punkten an den Leitungsresonator (L) angekoppelt sind.

4. Spannungsgesteuerter Oszillator nach Anspruch 3, dadurch gekennzeichnet, daß der erste Zweig (C1, C2) an dem ersten Ende (A) des Leitungsresonators (L) angekoppelt ist.

5. Spannungsgesteuerter Oszillator nach einem der Ansprüche 3 bis 4, dadurch gekennzeichnet, daß der zweite Zweig (C4, CD2) an dem zweiten Ende (B) des Leitungsresonators (L) angekoppelt ist.

6. Spannungsgesteuerter Oszillator nach einem der Ansprüche 3 bis 5, dadurch gekennzeichnet, daß der zweite Zweig (C4,. CD2) und der erste Ankoppelpunkt (D) auf unterschiedlichen Resonatorstücken an den Resonator (L) angekoppelt sind und daß sich das erste Resonatorstück zwischen diesen Resonatorstücken befindet.

7. Spannungsgesteuerter Oszillator nach einem der Ansprüche 3 bis 4, dadurch gekennzeichnet,
- daß der zweite Zweig (C4, CD2) in einen Grobzweig (C4a, CD2a) und in einen Feinzweig (C4b, CD2b) aufgeteilt ist;
- daß der Grobzweig (C4a, CD2a) an dem zweiten Ende (B) des Leitungsresonators (L) angekoppelt ist;
- daß der Feinzweig (C4b, CD2b) an einem zweiten Punkt (E) zwischen den beiden Resonatorenden (A, B) an den Leitungsresonator angekoppelt ist;
- daß die Lage dieses zweiten Ankoppelpunktes (E) so gewählt ist, daß der Grob- und der Feinzweig (C4a, CD2a; C4b, CD2b) über einen größeren, durch eine zweite untere und eine zweite obere Grenzfrequenz definierten Trägerfrequenzbereich, bezogen auf die räumliche Lage des Spannungsknoten (S) bei den Frequenzen aus diesem Bereich, auf der gleichen Seite des Leitungsresonators (L) liegen.

8. Spannungsgesteuerter Oszillator nach Anspruch 7, dadurch gekennzeichnet, daß der zweite Ankoppelpunkt (E) immer außerhalb eines zweiten Resonatorstückes liegt, welches durch die räumliche Lage des Spannungsknoten (S in FIG. 5) bei der zweiten oberen und bei der zweiten unteren Grenzfrequenz begrenzt ist.

9. Spannungsgesteuerter Oszillator nach einem der Ansprüche 7 bis 8, dadurch gekennzeichnet, daß die erste Beschaltungskapazität mit ihrem Grobzweig (C4a, CD2a) an den Ausgang des Integralzweiges eines Split-Loop-Filters (SF; vgl. FIG. 8) angeschlossen ist und mit ihrem Feinzweig (C4b, CD2b) an den Ausgang des Proportionalzweiges des gleichen Split-Loop-Filters (SF; vgl. FIG. 8) angeschlossen ist.

10. Spannungsgesteuerter Oszillator nach einem der Ansprüche 1 bis 9, dadurch gekennzeichnet, daß die variierbaren Teile der ersten und zweiten Beschaltungskapazität in Form von einseitig an Masse angeschlossenen Kapazitätsvariationsdioden (GD1, GD2; GD2a, GD2b) realisiert sind und daß die zur Kapazitätsvariation der Kapazitätsvariationsdioden (GD1, GD2; GD2, GD2b) erforderlichen Spannungen ($U_M$, $U_T$; $U_{TI}$, $U_{TP}$) über Filternetzwerke (40, 50; 50a, 50b) den Kapazitätsvariationsdioden (GD1, GD2; GD2a, GD2b) zugeführt sind.

11. Spannungsgesteuerter Oszillator nach einem der Ansprüche 1 bis 10, dadurch gekennzeichnet, daß die Gleichspannungsversorgung (7, 70) an einem dritten Punkt (C) zwischen den Resonatorenden (A, B) an den Leitungsresonator (L) angekoppelt ist und daß die Lage des dritten Ankoppelpunktes (L) so gewählt ist, daß sie mit der Lage des Spannungsknotens (S) bei der mittleren Trägerfrequenz übereinstimmt oder zumindest annähernd übereinstimmt.

12. Spannungsgesteuerter Oszillator nach einem der Ansprüche 1 bis 11, dadurch gekennzeichnet, daß der Leitungsresonator eine auf ein dielektrisches Substrat (DE in FIG. 4) aufgebrachte erste Streifenleitung (L) oder gedruckte Leitung (L) ist und daß das Substrat (DE) auf der der ersten Streifenleitung (L) oder gedruckte Leitungen (L) gegenüberliegenden Seite eine an Masse angeschlossene, durchgehende Metallisierung (ME in FIG. 4) aufweist.

13. Spannungsgesteuerter Oszillator nach Anspruch 12, dadurch gekennzeichnet, daß auf dem dielektrischem Substrat (DE in FIG. 4) parallel zur ersten Streifenleitung (L) oder gedruckten Leitung (L) eine kürzere zweite Streifenleitung (LA) oder gedruckte Leitung (LA) verläuft und daß diese zweite Streifenleitung (LA) oder gedruckte Leitung (LA) mit ihrem einen Ende an Masse und mit ihrem anderen Ende an den Ausgangszweig (C5, 6) des Oszillators angeschlossen ist.

14. Spannungsgesteuerter Oszillator nach einem der Ansprüche 1 bis 13, dadurch gekennzeichnet, daß der Leitungs resonator eine mit ihrem Außenleiter an Masse angeschlossene Koaxialleitung ist und daß der Außenleiter der Koaxialleitung in Höhe der Ankoppelpunkte (C; D; E) auf dem Innenleiter der Koaxialleitung Bohrungen zur Durchführung der Ankoppelleitungen der anzukoppelenden Baugruppen (7, 70; C3, CD1; C4b, CD2b) aufweist.

15. Spannungsgesteuerter Oszillator nach einem der Ansprüche 1 bis 14, gekennzeichnet durch die Anwendung als Teil einer digitalen Frequenzaufbereitung (Synthesizer).

16. Spannungsgesteuerter Oszillator nach Anspruch 15, gekennzeichnet durch die Anwendung als Teil eines tragbaren Funksprechgerätes.

FIG. 1

FIG. 2

FIG. 3

VCO

FIG. 5

FIG. 4

FIG. 6

VCO

FIG. 7

FIG. 8

FIG. 9